# EUROPEAN PATENT SPECIFICATION

(11) **EP 0 577 985 B1**
(45) Date of publication and mention of the grant of the patent: **12.02.1997**
(21) Application number: 93109120.1
(22) Date of filing: 07.06.1993
(51) Int. Cl.: H01L 31/0216, H01L 31/048

(54) **Amorphous semiconductor solar module having improved passivation**
Solarmodul aus amorphem Halbleiter mit verbesserter Passivierung
Module solaire en semi-conducteur amorphe ayant une passivation améliorée

(30) Priority: 08.06.1992 JP 174785/92; 12.05.1993 JP 135285/93
(43) Date of publication of application: 12.01.1994
(73) Proprietor: KANEGAFUCHI KAGAKU KOGYO KABUSHIKI KAISHA, Kita-ku Osaka-shi (JP)
(72) Inventor: Ishikawa, Atsuo, Akashi-shi, Hyogo-ken (JP); Endo, Toshihito, Akashi-shi (JP); Yamagishi, Hideo, Kobe-shi, Hyogo-ken (JP); Tawada, Yoshihisa, Kobe-shi, Hyogo-ken (JP)
(74) Representative: VOSSIUS & PARTNER

(56) References cited:
- EP-A- 0 343 628
- EP-A- 0 536 738
- DATABASE WPI Week 9040, Derwent Publications Ltd., London, GB; AN 90-301 915 ; & JP-A-2 214 129
- PATENT ABSTRACTS OF JAPAN vol. 14, no. 485 (C-772) 23 October 1990 ; & JP-A-22 02 909
- PATENT ABSTRACTS OF JAPAN vol. 12, no. 337 (E-657) 12 September 1988 ; & JP-A-63 099 581
- PATENT ABSTRACTS OF JAPAN vol. 11, no. 099 (E-493) 27 March 1987 ; & JP-A-61 251 176

## Description

The present invention relates to a solar module, and in particular to a photovoltaic device using an amorphous semiconductor, that is, an amorphous solar module. More particularly, it relates to a solar module for outdoor use having improved passivation.

EP-A-0 536 738 belongs to the state of the art according to Article 54(3) EPC and describes a solar cell module with improved weathering characteristics having an amorphous silicon solar cell element comprising a metal electrode layer, an amorphous silicon semiconductor layer, a transparent and conductive layer and a grid electrode being disposed in this order on a conductive substrate. The grid electrode is covered by a coat comprising an epoxy resin having a moisture permeability of 20 g/m².day. 0.1 mm or less.

The abstract AN 90-301915 in data base WPI, week 9040, Derwent Publications Ltd., London, Great Britain & JP-A-2 214 129 describes a sealing method for electronic parts e.g. solar cells which involves covering of the electronic parts with a protective film comprising EVA copolymer resin having a moisture permeability of 0.03 g.mm/m².day.

In contrast to crystalline solar cells, solar cells made from amorphous semiconductors, such as amorphous silicon, are characterized as being easily fabricated on various kinds of substrate, such as glass, metal, resin, and so forth, at relatively low temperatures. Accordingly, fairly small-scale solar modules, where a solar module is defined as, for example, a structure having a passivating layer over connected solar cells, are typically fabricated by forming a solar cell element comprising layers of conductive metal oxide, amorphous semiconductor and metal electrode on a glass substrate, and then passivating the structure by vacuum lamination of a resin sheet having an undercoated adhesive layer. Since a robust structure is required for practical use, it is necessary to strengthen this type of solar module, and as a result, larger-sized modules have usually been made by constructing an array of solar submodules on tempered or laminated glass, where each submodule comprises a conductive metal oxide layer, an amorphous semiconductor layer, and a metal electrode layer fabricated on a glass substrate. After making the electrical contacts, the module is passivated by vacuum lamination of a resin sheet which is undercoated with an adhesive layer.

A major problem in fabricating this type of large-scale solar module is that, as described above, the manufacturing process is complex, consisting of several steps, such as arranging the solar submodules on the tempered glass, making the electrical connections, vacuum laminating and so forth, in addition to the submodule fabrication steps. Further, because expensive vacuum equipment is required, there are other problems of increased manufacturing cost and reduced reliability.

The present invention has been realized in consideration of these kinds of problems inherent in the previous technology, and accordingly, the object of this invention is to provide a solar module which can be effectively passivated by using simple steps and convenient techniques.

In accomplishing the foregoing and related objects, the present invention provides a solar module comprising:
(a) a conductive metal oxide layer;
(b) an amorphous semiconductor layer;
(c) a back metal electrode; and
(d) a passivating resin layer,
wherein the conductive metal oxide layer, the amorphous semiconductor layer, the back metal electrode, and the passivating resin layer are formed on a transparent substrate in this order, and the passivating resin layer comprises a water vapor-resistant barrier layer having a permeability to water vapor of not more than 1 g/m²·day at a thickness of 100 µm (measured according to ASTM E 96-53 T).

Furthermore, in the solar module of the present invention, the water vapor barrier layer is made of a polyisobutylene resin.

In addition, in the solar module of the present invention, it is preferable that the passivating resin layer also contains an oxygen barrier layer which has a permeability to oxygen of not more than 0.1 cm³·mm/m²·day·atm (measured according to ASTM D 1434-58), such as a copolymer of ethylene and vinyl alcohol.

In the solar module of the present invention, degradation of the performance of the back metal electrode by water vapor is prevented because of the presence of the water vapor barrier layer in the passivating resin layer. In a preferred embodiment of the present invention, performance degradation resulting from oxidation of the back metal electrode by oxygen is prevented because the passivating resin layer also contains an oxygen barrier layer.

In another preferred embodiment of the present invention, a consequence of forming the passivating resin layer by coating is that the manufacturing steps and apparatus can be made simple and facile.

These and other aspects of the present invention will become better understood with regard to the following description, appended claims, and accompanying drawings in which:

Fig. 1 is a schematic illustration of one example of the solar module of the present invention.

Figs. 2-7 are a series of schematic drawings illustrating the manufacturing steps of an example of the solar module of the present invention.

Fig. 8 is a schematic illustration showing the edge structure of an example of the solar module of the present invention.

Fig. 9 is a schematic illustration showing the edge structure of an alternative example of the solar module of the present invention; and

Fig. 10 is a schematic illustration of the edge structure of a previous solar module type, as described in the Comparative Example 1.

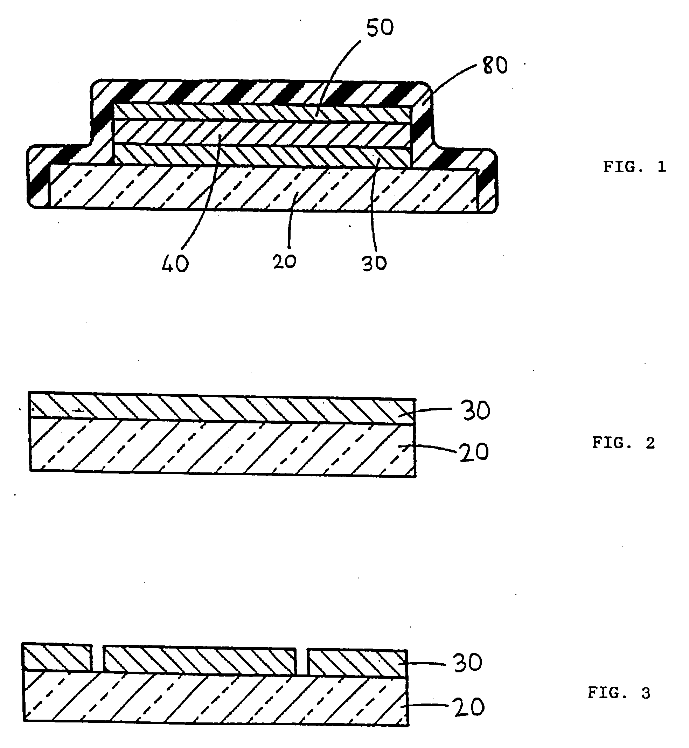

Fig. 1 is a schematic illustration of a solar module in accordance with the present invention. The module is made by the sequential stacking, on a transparent substrate 20, of layers in the order of a transparent conductive film 30, a semiconductor layer 40 and a back metal electrode 50, followed by passivation of the structure with a passivating resin layer 80. The active area of this solar module is not less than 0.05 m², and preferably not less than 0.1 m². Since vacuum lamination techniques become increasingly more difficult to apply as the size of the solar module increases, it becomes increasingly more advantageous to employ a polyisobutylene resin for the passivating layer, particularly with active areas greater than about 0.1 m².

For the transparent substrate 20, various materials such as plastic sheet or glass substrates can be used. In the case wherein the active area is relatively large, and in particular when it is not less than 0.5 m², tempered or laminated glass is preferably used in view of its resilience.

The transparent conductive film 30 can be SnO₂, indium tin oxide, indium oxide and the like, as used in previous solar modules.

The semiconductor layer 40 can be, for example, an amorphous semiconductor as in previous solar modules. In the present invention, an amorphous semiconductor represents a semiconductor comprising only an amorphous semiconductor and a semiconductor comprising an amorphous semiconductor containing crystallite substrate. a-Si:H; a-Si:H containing C, Ge, Sn or F; or µcSiH (microcrystalline) and the like are enumerated as specific examples of an amorphous semiconductor.

The back metal electrode 50 can be, for example, aluminum, as in previous solar modules.

For the oxygen barrier layer 60, materials having a permeability to oxygen of not more than 0.1 cm³·mm/m²·24 hr·atm can be used. There are many examples of this kind of material, such as polyvinylidene chloride; however, a resin made of a copolymer of ethylene and vinyl alcohol is especially preferred. This oxygen barrier layer is included in order to prevent corrosion, since oxygen acts to accelerate the corrosion of the back metal electrode 50 at high temperatures. The film thickness is usually not less than 1 µm, and is preferably about 20-40 µm.

For the water vapor barrier lager 70, polyisobutylene resin having rubber-like elasticity and having a permeability to water vapor of not more than 1 g/m²·24 hr at 100 µm film thickness is used. This kind of polyisobutylene resin is typically formed by the reaction of an isobutylene polymer having at least one functional group (X) in a molecule, with a curing agent having at least two functional groups (Y) in a molecule which can react with the functional group (X). From the viewpoint of retaining the elasticity of the formed resin, the functional group (X) is preferably located at the terminal of the polymer. A preferred example is a product formed by the addition reaction of an isobutylene polymer having a terminal C-C double bond with a compound having not less than two hydrosilyl groups. These examples are shown in JP-A-3-95266. For example, the curing agent is preferably a polysiloxane compound, such as cyclosiloxane, having at least two hydrosilyl groups. Examples which can be used are compositions of (A) a polyisobutylene oligomer formed by the reaction of a tertiary chloro terminated polyisobutylene with trimethylallylsilane or 1,9-decadiene, and (B) a curing agent which is the reaction product of 1,3,5,7-tetramethylcyclotetrasiloxane with 1,9-decadiene.

The polyisobutylene oligomer to be used in the present invention has a number average molecular weight of usually 500-100,000, and preferably 2,000-20,000. The oligomer is used in a mixture with a plasticizer such as polybutene, the mixture having a viscosity of 1,000-20,000 poise, which is convenient for application to solar modules.

The water vapor barrier layer 70 is included to prevent degradation of the back metal electrode 50 by water vapor, in a similar manner to the oxygen barrier layer 60. A film thickness of about 0.8-1.0 mm is used.

In this embodiment, the passivating resin layer 80 is formed as a stacked layer, made up of the oxygen barrier layer 60 and the water vapor barrier layer 70; however, it may consist only of a water vapor barrier layer 70. In addition, although not shown in the figure, a barrier layer may be included between the passivating resin layer 80 and the back metal electrode 50; for example, an insulating layer such as silicon oxide. This has the function of preventing the diffusion of atoms of halogen, alkali metal and alkaline earth metal, contained in the oxygen barrier layer 60 or water vapor barrier layer 70, into the solar cell element.

A detailed explanation of the present invention is given below, based on specific examples.

### Example 1

Using the thermal CVD method, an SnO₂ layer 30 of approximately 500 nm thickness was fabricated on a 4 mm thick, 500 mm by 600 mm soda glass substrate 20, after which the glass was tempered by heating and rapid cooling, thereby forming the conductive tempered glass substrate illustrated in Fig. 2. The SnO₂ layer 30 on the conductive tempered glass substrate was divided into 1-cm-wide electrical strips using the fundamental frequency of a YAG laser of wavelength about 1.06 µm. The resistances between the adjacent SnO₂ layers were each found to be not less than 1 Mohm. Following this, ultrasonic cleaning in pure water was carried out, resulting in the scribed conductive tempered glass shown in Fig. 3.

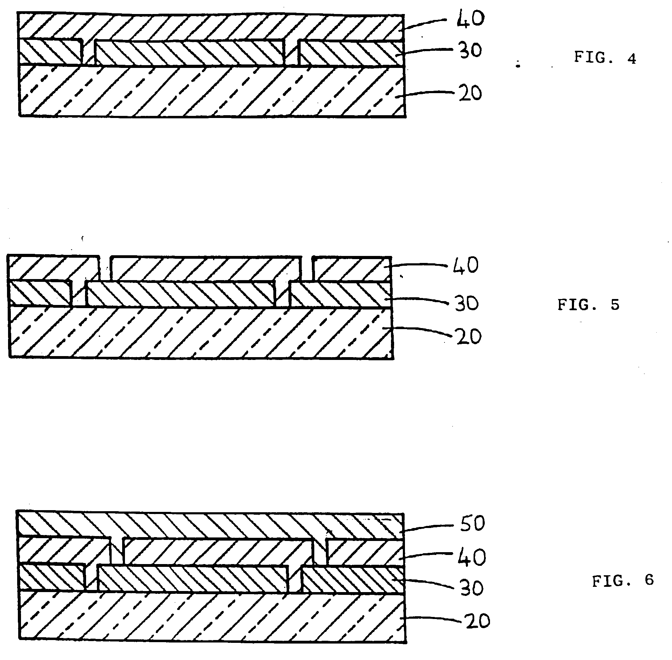

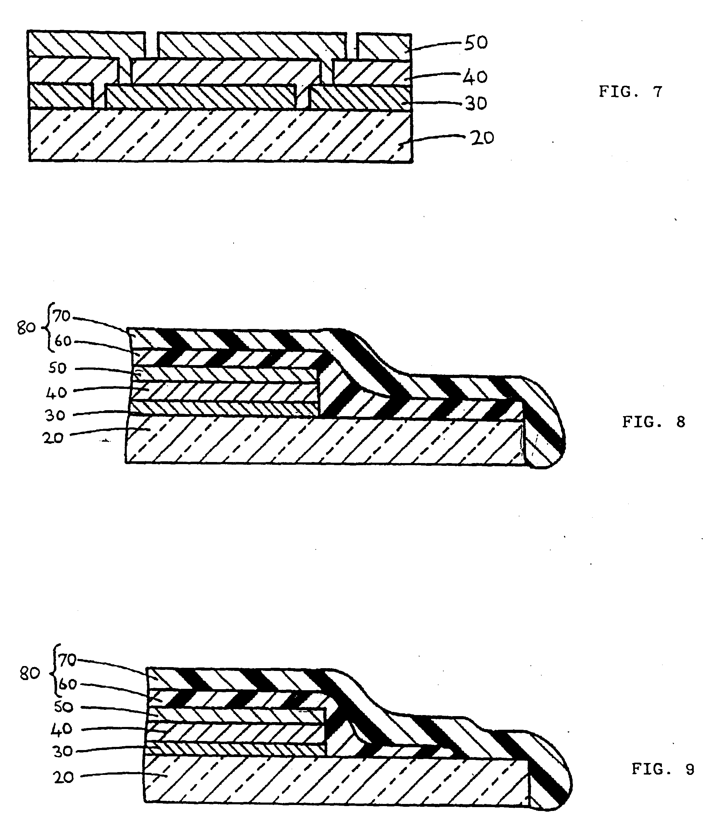

As illustrated in Fig. 4, a semiconductor layer 40 was fabricated over the scribed SnO₂ layer by forming layers of p-type amorphous silicon semiconductor, i-type amorphous silicon semiconductor and n-type microcrystalline silicon semiconductor of thickness 15 nm, 450 nm and 300 nm, respectively. These layers were fabricated in a capacitatively coupled glow discharge decomposition apparatus by decomposition of a gas mixture of SiH₄, CH₄ and B₂H₆, a gas mixture of SiH₄ and H₂, and a gas mixture of SiH₄, PH₃ and H₂, in that order, at a substrate temperature of 200°C and pressure of 66.66 - 133.32 Pa (0.5-1.0 Torr). After cooling, the amorphous semiconductor layer 40 was divided at positions offset by 50 µm from the scribed parts of the SnO₂ layer by utilizing a YAG laser, using its second harmonic to prevent damage to the SnO₂ layer 30 (see Fig. 5). Thereafter, for the back metal electrode 50, a thin aluminum film of thickness 250 nm was fabricated under vacuum at room temperature using an electron beam vapor deposition apparatus (see Fig. 6). After the glass substrate 20 was removed from the vapor deposition apparatus, the back metal electrode 50 was scribed at positions offset by 50 µm from the scribed part of the amorphous semiconductor layer 40 by a YAG laser, using its second harmonic to prevent damage to the amorphous semiconductor layer 40, to form an integrated solar module, as shown in Fig. 7. The dividing gaps formed by the laser scribing were about 50 µm, 150 µm and 150 µm for the SnO₂ layer 30, the amorphous semiconductor layer 40 and the back metal electrode 50, respectively. The obtained solar cell gave an output power of about 15 Watts under illumination of 100 mW/cm² AM-1.5 simulated sunlight.

A solution of a copolymer of ethylene and vinyl alcohol (for example, EVAL (Trade Name, made by Kuraray Co. Ltd.)) in dimethylsulfoxide solvent was coated onto the surface of the back metal electrode 50 of this solar module, so as to give a thickness after drying of about 20 µm, then stood at 130°C for about 30 min, and cured by evaporating off the solvent, to form an oxygen barrier layer 60. After cooling, a water vapor barrier layer 70 having polyisobutylene as the main constituent was formed by coating followed by thermal curing at 130°C for about 1 hr. Here, the edge of the glass was covered by the passivating resin 80 in order to prevent the infusion of water at the edge face. This structure is shown in Figs. 8 and 9. The polyisobutylene resin layer 70 was fabricated by using the following composition: 100 parts by weight of polyisobutylene oligomer, 100 parts by weight of polybutene, 9 parts by weight of DD4H, 120 parts by weight of SiO₂, 5 parts by weight of TiO₂, 5 parts by weight of carbon, and 1 part by weight of an anti-aging agent. The polyisobutylene resin had a molecular weight of about 5,000 and was prepared according to Example 11 of JP-A-3-152164. DD4H is 1,3,5,7-tetramethyl-1-{10-(1,3,5,7-tetramethylcyclotetracyloxanyl)-1-decyl}-cyclotetracyloxane, as described in Example 11 of JP-A-3-95266.

At the positions for electrical contacting, the resin was removed, electrical lead lines were connected by soldering, and the parts where the resin had been removed were then coated again with the above-described polyisobutylene composition and cured at 130°C. After cooling, the solar module was completed by covering the edge face of the passivating resin layer 80 - coated glass substrate 20 with an aluminum frame. A solar module fabricated in this way, having the structure shown in Fig. 9, gave an output power of 15 Watts under 100 mW/cm² AM-1.5 simulated sunlight.

### Example 2

A solar module was prepared in the same manner as Example 1, except that the glass substrate 20 had a size of 300 mm by 400 mm and a thickness of 3 mm. In order to evaluate the reliability of this module, the time-dependence of the module properties was studied under pressure cooker testing (test conditions: chamber temperature 127°C, relative humidity 80% RH, chamber pressure 2 atmospheres). Values of maximum output power measured during the test are shown normalized to the initial value in Table 1.

### Example 3

On the back metal electrode surface 50 of a solar cell element fabricated on a 3 mm thick, 300 mm by 400 mm glass substrate 20 in a manner similar to Example 1, a polyisobutylene resin layer, prepared as in Example 1, was coated directly and thermally cured at 130°C for about 1 hr to form a water vapor barrier layer 70. At the positions for electrical contact, the resin was removed, the electrical lead lines were connected by soldering, and the parts where the resin had been removed were again potted with polyisobutylene composition as in Example 1 and thermally cured at 130°C for 1 hr. After cooling, the edge face of the module was covered by an aluminum frame containing a thermoplastic butylene rubber to complete the solar module. The time-dependence of the properties of this solar module was then investigated by carrying out a pressure cooker test under the same conditions as Example 2. The results are also shown in Table 1.

### Comparative Example 1

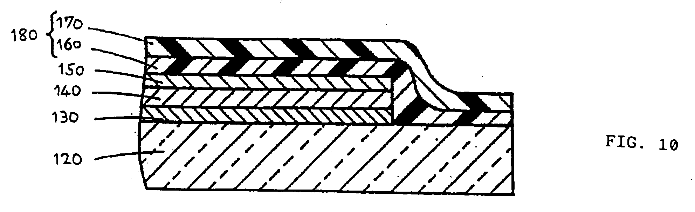

A solar module was fabricated on a 3 mm thick, 300 mm by 400 mm glass substrate 120 using a conventional vacuum laminating method. The structure, shown in Figure 10, comprised a glass substrate 120, a transparent conductive film 130, a semiconductor layer 140, a back metal electrode 150, and a passivating resin layer 180, comprising an ethylene-vinyl acetate copolymer resin film 160 and a film of aluminum foil sandwiched between polyvinyl fluoride (PVF) resin 170. This passivating resin layer 180 was fabricated as follows. An adhesive layer of ethylene vinyl acetate copolymer resin film 160 of thickness 600 µm was cut a little larger than the glass substrate 120 and positioned to cover the substrate 120. Thereon, a film of aluminum foil sandwiched between polyvinyl fluoride resin (PVF 38 µm/Al foil 30 µm/PVF 38 µm) 170 was similarly cut a little larger than the substrate 120, positioned on the substrate 120 and thermocompression-bonded using a vacuum laminating method. The time-dependence of the properties of this solar module was then investigated by carrying out a pressure cooker test under the same conditions as Example 2. The results are also shown in Table 1.

### Comparative Example 2

A solar module was fabricated in a similar manner to Comparative Example 1, except that a 100 µm thick polyethylene film was used in place of the aluminum foil-polyvinyl fluoride resin sandwich film 170 of Comparative Example 1 in fabricating the passivating resin layer 180. The water vapor permeability of the polyethylene layer was 2-3 g/m² · day. The time-dependence of the properties of this solar module was then investigated by carrying out a pressure cooker test under the same conditions as Example 2. The results are also shown in Table 1.

### Comparative Example 3

A solar module was fabricated in a similar manner to Comparative Example 1, except that a 100 µm thick polypropylene film having a water vapor permeability of about 1.5 g/m²·day was used in place of the aluminum foil-polyvinyl fluoride resin sandwich film 170 of Comparative Example 1 in fabricating the passivating resin layer 180. The time-dependence of the properties of this solar module was then investigated by carrying out a pressure cooker test under the same conditions as Example 2. The results are also shown in Table 1.

**Table 1**

| Normalized Maximum Output Power | | | | | |
|---|---|---|---|---|---|
| | Initial | 30 hr | 100 hr | 300 hr | 500 hr |
| Example 2 | 1.0 | 1.02 | 1.01 | 1.0 | 0.99 |
| Example 3 | 1.0 | 1.04 | 1.03 | 1.01 | 1.02 |
| Comp. Ex. 1 | 1.0 | 1.01 | 0.98 | 0.95 | 0.67 |
| Comp. Ex. 2 | 1.0 | 0.20 | 0.0 | 0.0 | 0.0 |
| Comp. Ex. 3 | 1.0 | 0.15 | 0.0 | 0.0 | 0.0 |

From Table 1, it can be seen that, in contrast to the Comparative Examples 1-3, the solar modules of the present invention show almost no degradation of the solar cell maximum output power after a pressure cooker test of 500 hr, which is a stringent test for electrical components.

As explained above, the solar module of the present invention has, in spite of its large area, excellent resistance to water vapor and oxygen. Therefore, since almost no degradation of performance occurs even after long periods of outdoor use, the solar modules have excellent reliability.

## Claims

1. A solar module comprising a glass substrate (20) having formed thereon, in order,
(a) a conductive metal oxide layer (30);
(b) an amorphous semiconductor layer (40);
(c) a back metal electrode (50); and
(d) a passivating resin layer (80);
wherein the passivating resin layer (80) comprises a water vapor barrier layer (70) having a permeability to water vapor of not more than 1 g/m²·day measured at a thickness of 100 µm, and wherein the water vapor barrier layer (70) comprises a polyisobutylene resin.

2. The solar module of claim 1 wherein the passivating resin layer (80) also comprises an oxygen barrier layer (60) having a permeability to oxygen of not more than 0.1 cm³·mm/m²·day·atm.

3. The solar module of claim 2 wherein the oxygen barrier layer (60) is comprised of a copolymer of ethylene and vinyl alcohol.

4. The solar module of any one of claims 1 to 3, wherein the active area of the solar module is not less than 0.1 m².

## Patentansprüche

1. Solarmodul mit einem Glassubstrat (20), auf dem in dieser Reihenfolge ausgebildet ist:
(a) eine leitende Metalloxidschicht (30);
(b) eine amorphe Halbleiterschicht (40);
(c) eine rückseitige Metallelektrode (50); und
(d) eine passivierende Harzschicht (80),
wobei die passivierende Harzschicht (80) eine Wasserdampfsperrschicht (70) mit einer Wasserdampfdurchlässigkeit von nicht mehr als 1 g/m²·Tag aufweist, die bei einer Dicke von 100 µm gemessen wurde, und wobei die Wasserdampfsperrschicht (70) ein Polyisobutylenharz aufweist.

2. Solarmodul nach Anspruch 1, wobei die passivierende Harzschicht (80) ferner eine Sauerstoffsperrschicht (60) mit einer Sauerstoffdurchlässigkeit von nicht mehr als 0.1 cm³· mm/m²·Tag·atm aufweist.

3. Solarmodul nach Anspruch 2, wobei die Sauerstoffsperrschicht (60) ein Copolymer von Ethylen und Vinylalkohol enthält.

4. Solarmodul nach einem der Ansprüche 1 bis 3, wobei die aktive Fläche des Solarmoduls nicht weniger als 0.1 m² beträgt.

## Revendications

1. Module solaire comportant un substrat de verre (20) présentant, formées sur lui, dans l'ordre,
(a) une couche d'oxyde métallique conducteur (30);
(b) une couche de semiconducteur amorphe(40);
(c) une électrode métallique arrière (50); et
(d) une couche de résine de passivation (80),
dans lequel la couche de résine de passivation (80) comporte une couche (70) formant barrière à la vapeur d'eau et présentant une perméabilité à la vapeur d'eau non supérieure à 1 g/m²·jour mesurée à une épaisseur de 100 µm et dans lequel la couche (70) formant barrière à la vapeur d'eau comporte une résine de polyisobutylène.

2. Module solaire de la revendication 1, dans lequel la couche de résine de passivation (80) comporte également une couche (60) formant barrière à l'oxygène et présentant une perméabilité à l'oxygène non supérieure à 0,1 cm³·mm/m²·jour·atm.

3. Module solaire de la revendication 2, dans lequel la couche (60) formant barrière à l'oxygène est composée d'un copolymère d'éthylène et d'alcool vinylique.

4. Module solaire de l'une quelconque des revendications 1 à 3, dans lequel la surface active du module solaire est non inférieure à 0,1 m².
